# EUROPEAN PATENT APPLICATION

(11) **EP 1 927 887 A2**
(43) Date of publication of application: **04.06.2008**
(21) Application number: 07021168.5
(22) Date of filing: 30.10.2007
(51) Int. Cl.: G02F 1/1362

(54) **Array substrate and display panel having the same**

(30) Priority: 29.11.2006 KR 20060118819
(71) Applicant: Samsung Electronics Co., Ltd., Yeongtong-gu Suwon-city, Gyeonggi-do 442-742 (KR)
(72) Inventor: Sohn, Woo-Sung, Gangnam-gu, Seoul (KR); Jung, Kyung-Suk, Iksan-si, Jeonlabuk-do (KR); Song, Sang-Heon, Asan-si, Chungcheongnam-do (KR)
(74) Representative: Dr. Weitzel & Partner

(57) **Abstract**

An array substrate includes a gate line part, a data line part, a pixel portion, at least one test transistor, and a test pad part. The gate line part is formed along a first direction, and includes gate lines and at least one dummy gate line (114). The data line part is formed along a second direction crossing the first direction, and includes data lines and at least one dummy data line (124). The pixel portion is electrically connected to the gate lines and the data lines. At least one test transistor (140) is electrically connected to the dummy gate line and the dummy data line. The test pad part (150) is electrically connected to the dummy gate line, the dummy data line and a drain electrode of the test transistor.

## Description

### BACKGROUND OF THE INVENTION

### 1. Field of the Invention

The present invention relates to an array substrate and a display panel having the array substrate. More particularly, the present invention relates to an array substrate capable of measuring characteristics of a thin film transistor and a display panel having the array substrate.

### 2. Description of the Related Art

A liquid crystal display ("LCD") apparatus, e.g., a flat display apparatus, displays an image using electrical and optical characteristics of a liquid crystal. The LCD apparatus is becoming more widely used because it is relatively small in size, lightweight, and is driven using relatively low power consumption and driving voltage.

The LCD apparatus includes an LCD panel displaying the image using light transmissivity of the liquid crystal, and a backlight assembly disposed under the LCD panel that provides light to the LCD panel.

The LCD panel includes an array substrate, an opposite substrate facing the array substrate, and a liquid crystal layer disposed between the array substrate and the opposite substrate. The array substrate may include a gate line formed along a first direction, a data line formed along a second direction perpendicular to the first direction, a thin film transistor ("TFT") electrically connected to the gate line and the data line, and a transparent pixel electrode electrically connected to the TFT.

When the LCD panel is driven for a long time to display the image, the TFT characteristics generally change. Thus, a method to measure the TFT characteristics after driving the LCD panel is necessary.

Conventionally, the TFT characteristics may be measured through a decap process that eliminates the opposite substrate from the array substrate. However, the measurement through the decap process destroys the LCD panel, and is not accurate because static electricity flows into the TFT, thereby interfering with the measurements.

### BRIEF SUMMARY OF THE INVENTION

The present invention provides an array substrate that accurately measures thin film transistor characteristics in real time.

The present invention also provides a display panel having the array substrate.

In one exemplary embodiment of the array substrate according to the present invention, the array substrate includes a gate line part, a data line part, a pixel portion, at least one test transistor, and a test pad part. The gate line part is formed along a first direction, and includes gate lines and at least one dummy gate line. The data line part is formed along a second direction crossing the first direction, and includes data lines and at least one dummy data line. The pixel portion is electrically connected to the gate lines and the data lines. At least one test transistor is electrically connected to the dummy gate line and the dummy data line. The test pad part is electrically connected to the dummy gate line, the dummy data line and a drain electrode of the test transistor. The test pad part includes a gate test pad electrically connected to the dummy gate line, a data test pad electrically connected to the dummy data line, and a drain test pad electrically connected to the drain electrode of the transistor.

The array substrate may further include a gate driving part which applies gate signals to the gate lines, and applies a dummy gate signal to the dummy gate line, and a data driving part which applies data signals to the data lines, and applies a dummy data signal to the dummy data line.

In one exemplary embodiment of a display panel according to the present invention, the display panel includes an array substrate, an opposite substrate covering a first area, and a liquid crystal layer formed between the array substrate and the opposite substrate. The array substrate includes: a first area; a second area formed outside of the first area; a gate line part formed along a first direction wherein the gate line part includes gate lines and at least one dummy gate line; a data line part formed along a second direction crossing the first direction, including data lines and at least one dummy data line; a pixel portion formed in the first area and electrically connected to the gate lines and the data lines; at least one test transistor electrically connected to the dummy gate line and the dummy data line; and a test pad part formed in the second area and electrically connected to the dummy gate line, the dummy data line and a drain electrode of the test transistor.

According to the present invention, the dummy gate line, the dummy data line and the test pad part electrically connected to the test transistor may be formed in the array substrate, so that the test transistor includes the same characteristics as the thin film transistor and may be accurately measured in real time.

### BRIEF DESCRIPTION OF THE DRAWINGS

The above and other aspects, features and advantages of the present invention will become more apparent by describing in detailed example embodiments thereof with reference to the accompanying drawings, in which:
FIG. 1 is a plan view illustrating an exemplary embodiment of a display panel according to the present invention;
FIG. 2 is a plan view illustrating an exemplary portion of an opposite substrate from FIG. 1;
FIG. 3 is a plan view enlarging portion A of FIG. 2;
FIG. 4 is a circuit diagram illustrating a first exemplary embodiment of connections among a dummy gate line, a dummy data line, a test transistor and a test pad portion;
FIG. 5 is a plan view illustrating a second exemplary embodiment of connections different from the first exemplary embodiment connections in FIG. 4;
FIG. 6 is a plan view illustrating a third exemplary embodiment of connections different from the second exemplary connections in FIG. 5;
FIG. 7 is a graph showing a variation of test transistor characteristics;
FIG. 8 is a plan view illustrating a plurality of test pad parts disposed in FIG. 1;
FIG. 9 is a plan view illustrating another exemplary embodiment of a display panel according to the present invention; and
FIG. 10 is a plan view illustrating another exemplary embodiment of a display panel according to the present invention.

### DETAILED DESCRIPTION OF THE INVENTION

The invention now will be described more fully hereinafter with reference to the accompanying drawings, in which exemplary embodiments of the invention are shown. The present invention may, however, be embodied in many different forms and should not be construed as limited to the embodiments set forth herein. Rather, these embodiments are provided so that this disclosure will be thorough and complete, and will fully convey the scope of the invention to those skilled in the art. It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Exemplary embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention. Hereinafter, the exemplary embodiments of the present invention will be explained in detail with reference to the accompanying drawings.

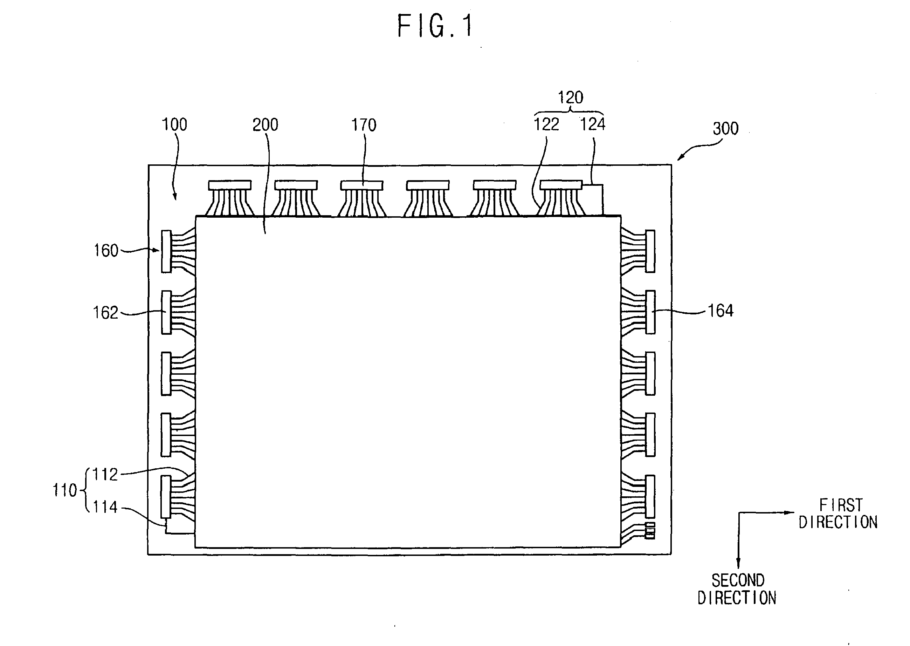

FIG. 1 is a plan view illustrating an exemplary embodiment of a display panel 300 according to the present invention.

Referring to FIG. 1, the display panel 300 according to the present exemplary embodiment includes an array substrate 100, an opposite substrate 200 and a liquid crystal layer (not shown).

The array substrate 100 is disposed in a matrix shape. In one exemplary embodiment, the array substrate 100 includes a plurality of pixel electrodes that is transparent and conductive, TFTs applying driving voltage to each pixel electrode, and a signal line operating each TFT.

The opposite substrate 200 is disposed to face the array substrate 100. In one exemplary embodiment, the opposite substrate 200 includes a common electrode (not shown) that is disposed over the opposite substrate 200 and is conductive, and color filters (not shown) that share a one-to-one correspondence with the unit pixels.

The liquid crystal layer is disposed between the array substrate 100 and the opposite substrate 200, and a longitudinal arrangement of liquid crystal molecules in the liquid crystal layer is changed by an electric field generated between the pixel electrodes and the common electrode. Thus, the liquid crystal layer changes light transmissivity of light applied from an external source.

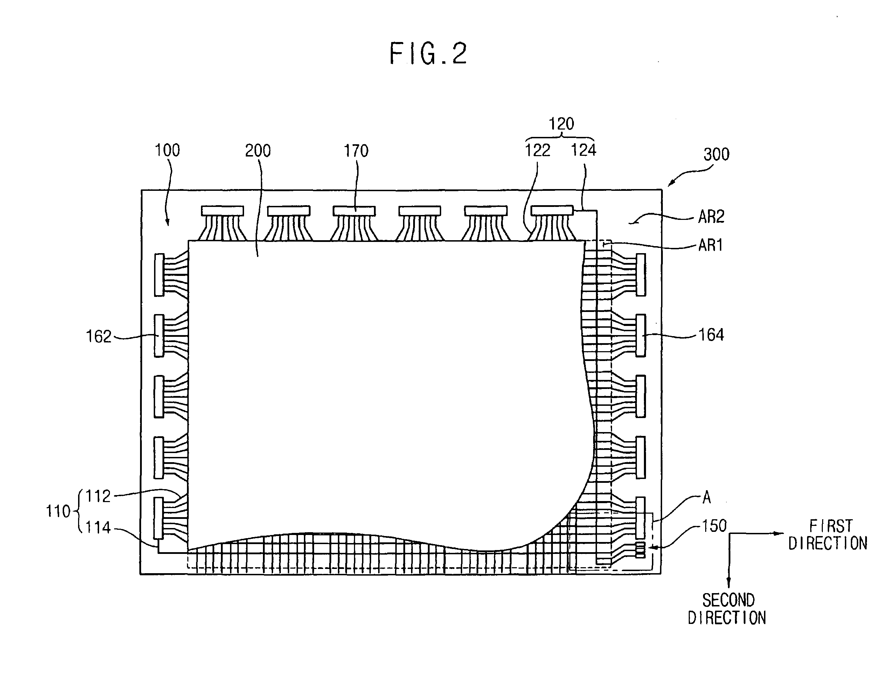

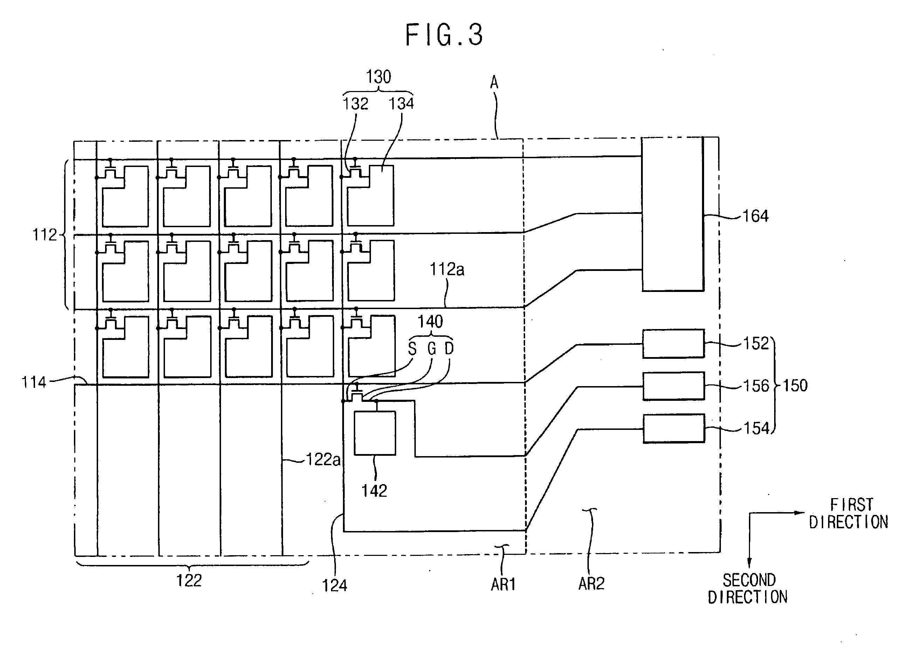

FIG. 2 is a plan view illustrating a portion of the opposite substrate 200 shown in FIG. 1. FIG. 3 is a plan view enlarging portion A of FIG. 2.

Referring to FIGS. 1, 2 and 3, the array substrate 100 according to the present exemplary embodiment, is divided into a first area AR1 and a second area AR2 formed outside of the first area AR1. The array substrate 100 includes a gate line part 110, a data line part 120, a pixel portion 130, a test transistor 140, a test pad part 150, a gate driving part 160, and a data driving part 170. The first area AR1 of the array substrate 100 is an area covered by the opposite substrate 200.

The gate line part 110 is formed along a first direction, and includes gate lines 112 and at least one dummy gate line 114. The gate lines 112 and the dummy gate line 114 may be formed in the first and second areas AR1 and AR2 of the array substrate 100 along the first direction.

The dummy gate line 114 is formed at at least one side of the gate lines 112. In FIG. 2, one exemplary embodiment shows the dummy gate line 114 formed at a lower side of the gate lines 112. The dummy gate line 114 may be electrically separated from an outermost gate line 112a that is formed at an outermost side among the gate lines 112, and may be electrically connected to the outermost gate line 112a.

The data line part 120 is formed along a second direction crossing the first direction, and includes data lines 122 and at least one dummy data line 124. The second direction may be perpendicular to the first direction, and the data lines 122 and at least one dummy data line 124 may be formed in the first and second areas AR1 and AR2 along the second direction.

The dummy data line 124 is formed at at least one side of the data lines 122. In FIG. 2, one exemplary embodiment shows the dummy data line 124 formed at a right side of the data lines 122. The dummy data line 124 may be electrically separated from an outermost data line 122a that is formed at an outermost side among the data lines 122, and may be electrically connected to the outermost data line 122a.

The pixel portion 130 is formed in the first area AR1 of the array substrate 100, and is electrically connected to the gate lines 112 and the data lines 114. The pixel portion 130 includes the TFTs 132 and the pixel electrodes 134.

A gate electrode of the TFTs 132 is electrically connected to the gate lines 112, and a source electrode of the TFTs 132 is electrically connected to the data lines 122.

In one embodiment, the pixel electrodes 134 may be formed in unit pixels as defined by the gate lines 112 and the data lines 122, and may be electrically connected to a drain electrode of the TFTs 132. The pixel electrodes 134 include a transparent conductive material, e.g., indium tin oxide ("ITO"), indium zinc oxide ("IZO"), and amorphous indium tin oxide ("a-ITO").

At least one test transistor 140 is formed in the first area AR1 of the array substrate 100, and is electrically connected to the dummy.gate line 114 and the dummy data line 124. In this exemplary embodiment, a gate electrode G of the test transistor 140 is electrically connected to the dummy gate line 114, and a source electrode S of the test transistor 140 is electrically connected to the dummy data line 124.

At least one dummy pixel electrode 142 electrically connected to a drain electrode D of the test transistor 140 is further formed in the first area AR1 of the array substrate 100. Accordingly, when the dummy pixel electrode 142 is further formed, the TFTs 132 and the test transistor 140 may be connected as described above with respect to the test transistor 140. However, the dummy pixel electrode 142 may be eliminated.

The test pad part 150 is formed in the second area AR2 of the array substrate 100, and electrically connected to the dummy gate line 114, the dummy data line 124, and the drain electrode D of the test transistor 140. The test pad part 150 is disposed adjacent to a gate driving part 160 or a data driving part 170 that will be explained below. In one exemplary embodiment as shown in FIGS. 1 and 2, the test pad part 150 may be disposed adjacent to the gate driving part 160.

For example, the test pad part 150 includes a gate test pad 152 electrically connected to the dummy gate line 114, a data test pad 154 electrically connected to the dummy data line 124, and a drain test pad 156 electrically connected to the drain electrode D of the test transistor 140.

The test pad part 150 makes contact with probe pins of the test unit (not shown) that is used for measuring characteristics of the test transistor 140, to receive test signals.

The gate driving part 160 is formed in the second area AR2 of the array substrate 100, and is electrically connected to the gate lines 112 and the dummy gate line 114. Accordingly, the gate driving part 160 applies gate signals to the gate lines 112, and applies a dummy gate signal to the dummy gate line 114.

In one exemplary embodiment, the plurality of gate driving parts 160, 162, 164 may be disposed along the second direction as shown in Figures 1, 2 and 3. In another exemplary embodiment, one gate driving part 160, 162, 164 may be disposed to have an extended shape along the second direction..

In addition, as illustrated in FIGS. 1 and 2, the gate driving part 160, 162, 164 may be disposed at both sides of the gate lines 112 and the dummy gate line 114, to be electrically connected to both terminals of the gate lines 112 and the dummy gate line 114. In another exemplary embodiment, the gate driving part 160, 162, 164 may be disposed at one side of the gate lines 112 and the dummy gate line 114, and may be electrically connected to one terminal of the gate lines 112 and the dummy gate line 114.

The dummy gate signal applied to the dummy gate line 114 may be different from the gate signals applied to the gate lines 112. In one exemplary embodiment, the dummy gate signal applied to the dummy gate line 114 is equal to the gate signals applied to the gate lines 112. In a further exemplary embodiment, the dummy gate line 114 is electrically connected to the outermost gate line 112a formed at the outermost side among the gate lines 112, so that the gate signal applied to the outermost gate line 112a may be applied to the dummy gate line 114.

The data driving part 170 is formed in the second area AR2 of the array substrate 100, and is electrically connected to the data lines 122 and the dummy data line 124. Accordingly, the data driving part 170 applies data signals to the data lines 122, and applies the dummy data signal to the dummy data line 124.

The data driving part 170 may be disposed at one side of the data lines 122 and the dummy data line 124, and electrically connected to one side of the data lines 122 and the dummy data line 124. A plurality of the data driving parts 170 may be disposed along the first direction, and in another exemplary embodiment, one data driving part 170 may be disposed to have the extended shape along the first direction. In one exemplary embodiment, the plurality of data driving parts 170 may be disposed along the first direction as illustrated in the Figures 1 and 2.

The dummy data signal applied to the dummy data line 124 may be different from the data signals applied to the data lines 122. In one exemplary embodiment, the dummy data signal applied to the dummy data line 124 is equal to the data signals applied to the data lines 122. In a further exemplary embodiment, the dummy data line 124 is electrically connected to the outermost data line 122a formed at the outermost side among the data lines 122, so that the data signal applied to the outermost data line 122a may be applied to the dummy data line 124.

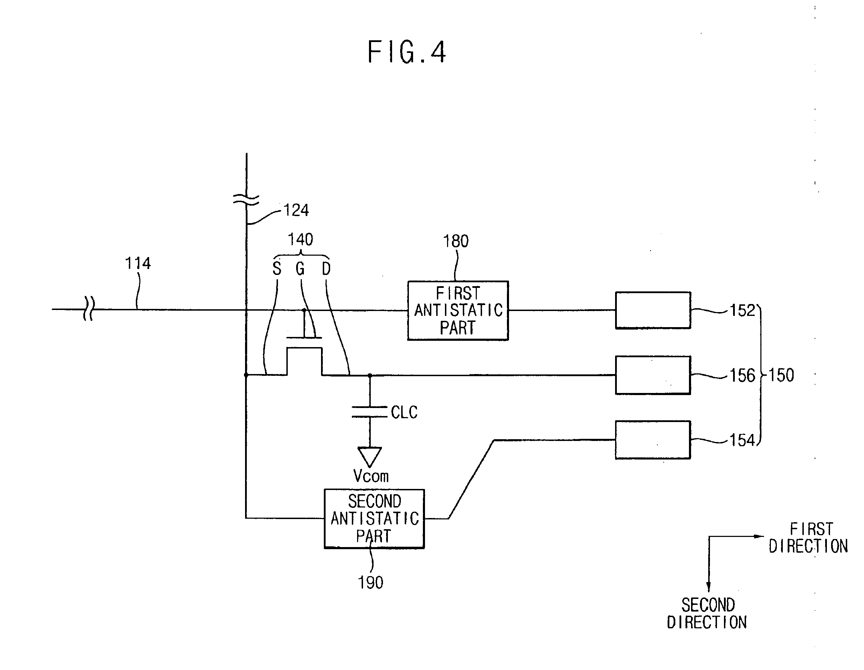

FIG. 4 is a circuit diagram illustrating a first exemplary embodiment of connections among a dummy gate line, a dummy data line, a test transistor and a test pad portion.

Referring to FIG. 4, the dummy gate line 114 extends lengthwise along the first direction, so that a terminal of the dummy gate line 114 is electrically connected to the gate test pad 152. The dummy data line 124 extends lengthwise along the second direction perpendicular to the first direction, so that a terminal of the dummy data line 124 is electrically connected to the data test pad 154.

The gate electrode G of the test transistor 140 is electrically connected to the dummy gate line 114, the source electrode S of the test transistor 140 is electrically connected to the dummy data line 124, and the drain electrode of the test transistor 140 is electrically connected to the drain test pad 156.

In addition, the drain electrode D of the test transistor 140 is electrically connected to a first electrode of liquid crystal capacitor CLC. In this case, the first electrode of the liquid crystal capacitor CLC is a dummy pixel electrode, and a second electrode includes a common electrode Vcom formed on the opposite substrate.

The array substrate 100 further includes a first antistatic part 180 disposed between the dummy gate line 114 and the gate test pad 152, and a second antistatic part 190 disposed between the dummy data line 124 and the data test pad 154.

In one exemplary embodiment, the first antistatic part 180 includes a first terminal is electrically connected to the dummy gate line 114, and a second terminal is electrically connected to the gate test pad 152. The second antistatic part 190 includes a first terminal is electrically connected to the dummy data line 124, and a second terminal is electrically connected to the data test pad 154. The first and second antistatic parts 180 and 190 include an electro-static diode not shown.

Accordingly, when the first antistatic part 180 is disposed between the dummy gate line 114 and the gate test pad 152, and the second antistatic part 190 is disposed between the dummy data line 124 and the data test pad 154, static electricity generated when probe pins of the test unit make contact with the test pad part 150, is applied to the test transistor 140, so that the characteristics of the test transistor 140 does not change.

A third antistatic part (not shown) may be further disposed between the drain electrode D of the test transistor 140 and the drain test pad 156.

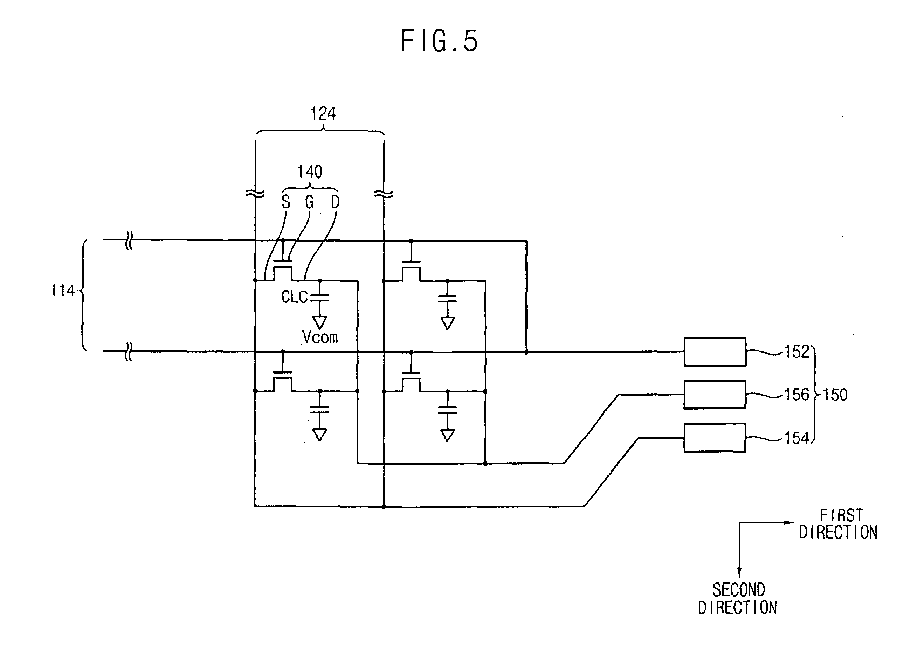

FIG. 5 is a plan view illustrating a second exemplary embodiment of connections different from the first exemplary connections shown in FIG. 4.

Referring to FIG. 5, a plurality of dummy gate lines 114, a plurality of dummy data lines 124, and a plurality of test transistors 150 may be formed. One exemplary embodiment includes the dummy gate lines 114 and the dummy data lines 124 formed in plural.

For example, two dummy gate lines 114 may be formed in parallel along the first direction, and two dummy data lines 124 may be formed in parallel along the second direction. Four test transistors may be disposed in two rows and two columns, so that they are electrically connected to two dummy gate lines 114 and two dummy data lines 124.

Each of the dummy gate lines 114 may be electrically connected to the gate test pads 152 and each of the dummy data lines 124 may be electrically connected to the data test pads 154, however, all of the dummy gate lines 114 are electrically connected to one gate test pad 152 and all of the dummy data lines 124 are electrically connected to one data test pad 154. In addition, all of the drain electrodes D of the test transistors 140 are electrically connected to one drain test pad 156.

Accordingly, all of the dummy gate lines 114, the dummy data lines 124 and the test transistors 150 are formed in plural, so that the characteristics of the plurality of test transistors 150 may be measured at the same time. Thus, reliability of the measured characteristics of the test transistor 150 may be further enhanced.

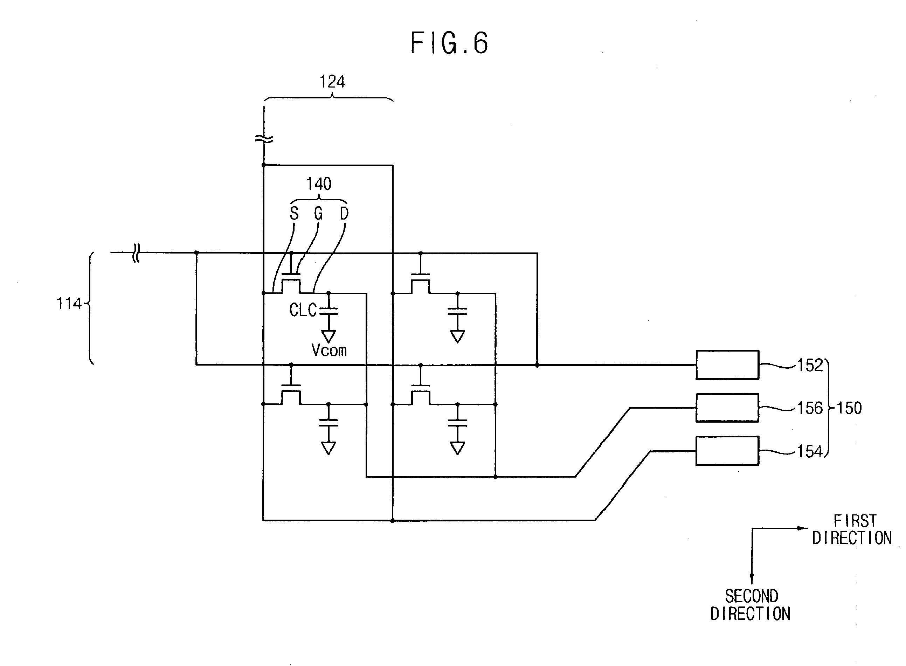

FIG. 6 is a plan view illustrating a third exemplary embodiment of connections different from the second exemplary connections in FIG. 5.

Referring to FIG. 6, at least two dummy gate lines 114 may be short-circuited, and at least two dummy data lines 124 may be short-circuited.

Particularly, two dummy gate lines 114 are electrically shorted to each other, and two dummy data lines 124 are electrically shorted to each other. In this case, the dummy gate lines 114 are electrically shorted to each other at a forward terminal of the test transistors 140, and the dummy data lines 124 are electrically shorted to each other at the forward terminal of the test transistors 140. In one exemplary embodiment, the dummy gate lines 114 are electrically shorted to each other at a left side of the test transistors 140, and the dummy data lines 124 are electrically shorted to each other at an upper side of the test transistors 140.

Accordingly, the dummy gate lines 114 are electrically shorted to each other at the forward terminal of the test transistors 140 and the dummy data lines 124 are electrically shorted to each other at the forward terminal of the test transistors 140, so that one dummy gate signal and one dummy data signal may be applied to the test transistors 140 at the same time.

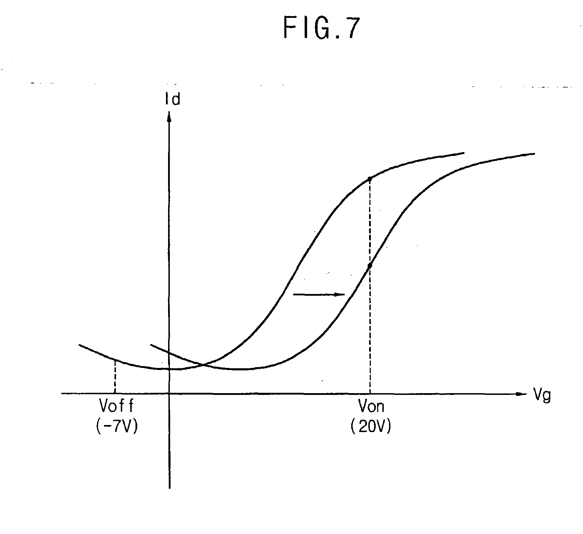

FIG. 7 is a graph showing a variation of test transistor characteristics.

The test transistor 140 formed in the array substrate 100 has the electrical characteristics illustrated in FIG. 7.

Particularly, in one exemplary embodiment when a source voltage of 10 V is uniformly applied to the source electrode S of the test transistor 140, a drain current Id flowing in the drain electrode is gradually increased accordingly as a gate voltage Vg applied to the gate electrode G is gradually increased. However, when the gate voltage Vg is continuously increased, an increasing ratio of the drain current Id is decreased, so that the drain current Id becomes constant. Accordingly as the gate voltage Vg is gradually decreased, the drain current Id is gradually decreased. However, when the gate voltage Vg is continuously decreased, the drain current Id is decreased to a certain extent and then is increased again.

The gate voltage Vg generally may include a gate-on voltage Von and a gate-off voltage Voff. In one exemplary embodiment, the gate-on voltage Von is about 20 V, and the gate-off voltage is about -7 V. When the gate voltage Vg has the gate-on voltage Von, the drain current Id has a relatively high value. When the gate voltage Vg has the gate-off voltage Voff, the drain current Id has a relatively low value.

When the display panel 300 is in operation for an extended period of time, a characteristic curve of the test transistor 140 may move to left or right, but generally, the characteristic curve moves to the right. Accordingly, when the characteristic curve of the test transistor 140 moves to the right side, the drain current Id, when the gate voltage Vg equals the gate-on voltage Von, becomes lower than the previous drain current ld, and the drain current Id, when the gate voltage Vg equals the gate-off voltage Voff, becomes higher than the previous drain current Id. Therefore, the electric characteristics-of the test transistor 140 diminish.

Thus, the characteristics of the test transistor 140 should be measured accordingly as the display panel 300 is driven. In this case, the characteristics of the test transistor 140 are almost the same as the TFTs 132, so that the test transistor 140 may be representing the TFTs 132.

According to the present invention, the test pad part 150 is electrically connected to the dummy gate line 114, and the dummy data line 124 and the drain electrode S of the test transistor 140 are formed on the array substrate 100, so that the characteristics of the test transistor 140, having the same characteristics of the TFTs 132, may be accurately measured in real time.

For example, the display panel 300 may be driven for an extended period of time, and thus a constant data test voltage is therefore applied to the data test pad 154. A varying gate test voltage may be applied to the gate test pad 152, and a drain test voltage is measured from the drain test pad 156, so that the characteristics of the test transistor 140 are measured in real time.

In addition, the method of measuring the characteristics of the test transistor 140 by the test pad portion 150, the conventional decap process of eliminating the opposite substrate 200 from the array substrate 100 is omitted, so that the static electricity does not flow in the display panel 300 and therefore the display panel 300 is not destroyed.

In addition, signal delay of the gate and data signals may be measured by using the test pad part 150.

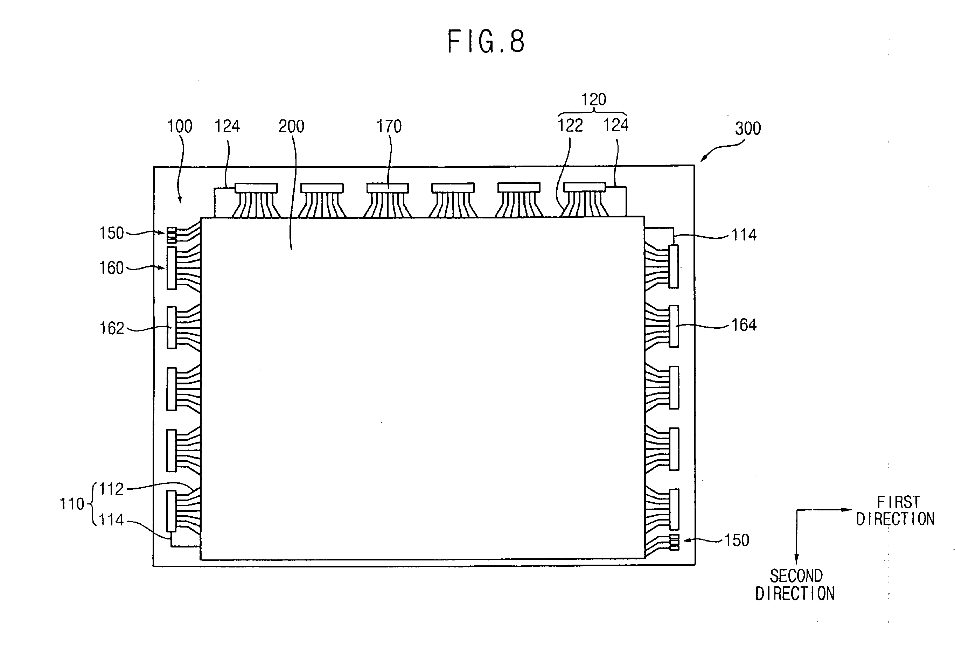

FIG. 8 is a plan view illustrating a plurality of test pad parts disposed in FIG. 1.

Referring to FIG. 8, a plurality of test pad parts 150 may be formed. In one exemplary embodiment, a pair of test pad parts 150 may be formed to diagonally face each other in the second area AR2.

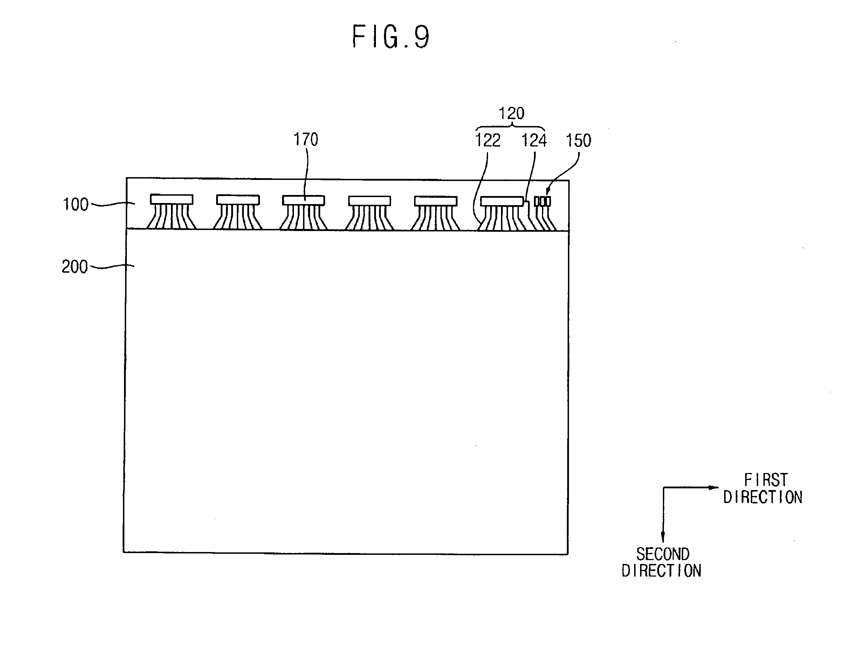

FIG. 9 is a plan view illustrating another exemplary embodiment of a display panel according to the present invention.

Referring to FIG. 9, the data driving part 170 is disposed in the second area AR2, but the gate driving part 160 is disposed in the first area AR1 not in the second area AR2, so that the gate driving part 160 may be covered by the opposite substrate 200. For example, the gate driving part 160 may be a circuit formed by additional TFTs 132.

In one exemplary embodiment, the second area AR2 may be formed at the upper side, and the test pad part 150 may be formed adjacent to the data driving part 170 in the second area AR2.

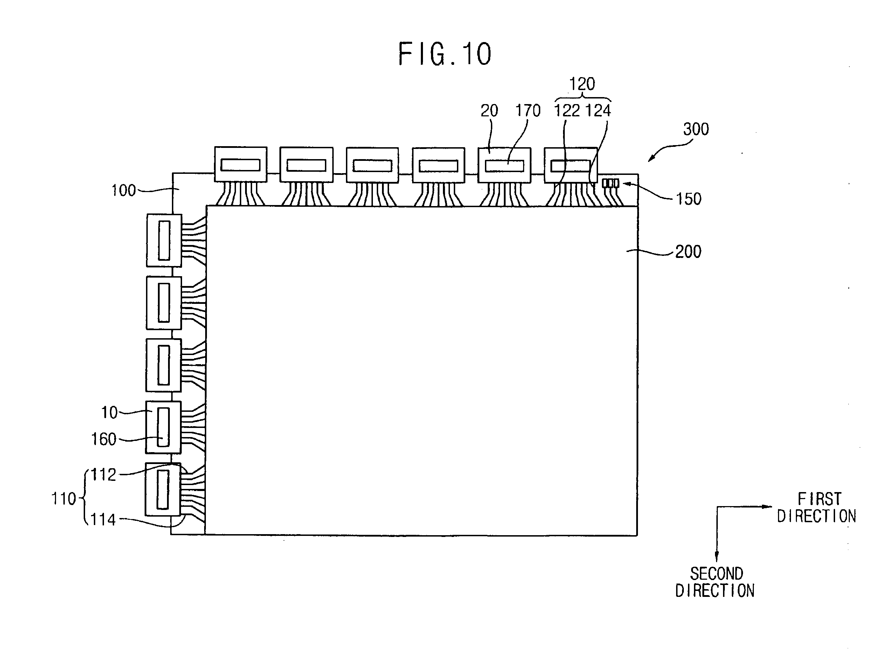

FIG. 10 is a plan view illustrating another exemplary embodiment of a display panel according to the present invention.

Referring to FIG. 10, the display panel 300 may further include a gate printed circuit board ("PCB") 10 and a data PCB 20.

The gate PCB 10 is overlapped with the second area AR2 of the array substrate 100, and electrically connected to one terminal of the gate line 112 and one terminal of the dummy gate line 114. In this embodiment, the gate driving part 160 is mounted on a side surface of the gate PCB 10, so that the gate driving part 160 is electrically connected to the gate line 112 and the dummy gate line 114.

In addition, the data PCB 20 is overlapped with the second area AR2 of the array substrate 100, and is electrically connected to one terminal of the data line 122 and one terminal of the dummy data line 124. In this embodiment, the data driving part 170 is mounted on a side surface of the data PCB 20, so that the data driving part 170 is electrically connected to the data line 122 and the dummy data line 124.

According to the present invention, the test pad part may be electrically connected to the dummy gate line, and the dummy data line and the drain electrode of the test transistor are formed on the array substrate, so that the test transistor characteristics have the same characteristics as the TFTs, therefore the TFTs may be accurately measured in real time.

In addition, when the test transistor characteristics are measured by using the test pad part, the decap process eliminating the opposite substrate from the array substrate is omitted, therefore the static electricity does not flow in the display panel and the display panel is not destroyed.

In addition, signal delay of the gate and data signals may be measured by using the test pad part.

Having described the example embodiments of the present invention and its advantage, it is noted that various changes, substitutions and alterations can be made herein without departing from the spirit and scope of the invention as defined by appended claims.

## Claims

1. An array substrate comprising:
a gate line part formed along a first direction, the gate line part including gate lines and at least one dummy gate line;
a data line part formed along a second direction crossing the first direction, the data line part including data lines and at least one dummy data line;
a pixel portion electrically connected to the gate lines and the data lines;
at least one test transistor electrically connected to the dummy gate line and the dummy data line; and
a test pad part electrically connected to the dummy gate line, the dummy data line and a drain electrode of the test transistor.

2. The array substrate of claim 1, wherein the test pad part includes:
a gate test pad electrically connected to the dummy gate line;
a data test pad electrically connected to the dummy data line; and
a drain test pad electrically connected to the drain electrode of the test transistor.

3. The array substrate of claim 2, further comprising:
a first antistatic part electrically connected between the dummy gate line; and
a second antistatic part electrically connected between the dummy data line and the data test pad.

4. The array substrate of claim 3, wherein the first and second antistatic parts include an electro-static diode.

5. The array substrate of claim 2, further comprising:
a gate driving part applying gate signals to the gate lines, and applying a dummy gate signal to the dummy gate line; and
a data driving part applying data signals to the data lines, and applying a dummy data signal to the dummy data line.

6. The array substrate of claim 5, wherein the dummy gate line lies adjacent to the gate lines, and the dummy data line lies adjacent to the data lines.

7. The array substrate of claim 6, wherein the dummy gate signal equals the gate signals, and the dummy data signal equals the data signals.

8. The array substrate of claim 7, wherein the dummy gate line is electrically connected to an outermost gate line, and the dummy data line is electrically connected to an outermost data line.

9. The array substrate of claim 2, wherein at least more than two dummy gate lines are electrically shorted to each other at a forward terminal of the test transistors.

10. The array substrate of claim 2, wherein at least more than two dummy data lines are electrically shorted to each other at a forward terminal of the test transistors.

11. The array substrate of claim 1, further comprising at least one dummy pixel electrode electrically connected to a drain electrode of the test transistor.

12. The array substrate of claim 1, wherein the pixel portion includes:
thin film transistors electrically connected to the gate lines and the data lines; and
pixel electrodes electrically connected to drain electrodes of the thin film transistors, respectively.

13. A display panel comprising:
an array substrate including:
a first area;
a second area formed outside of the first area;
a gate line part formed along a first direction, the gate line part including gate lines and at least one dummy gate line;
a data line part formed along a second direction crossing the first direction, the data line part including data lines and at least one dummy data line;
a pixel portion formed in the first area, and electrically connected to the gate lines and the data lines;
at least one test transistor electrically connected to the dummy gate line and the dummy data line; and
a test pad part formed in the second area, and electrically connected to the dummy gate line, the dummy data line and a drain electrode of the test transistor,
an opposite substrate covering the first area; and
a liquid crystal layer formed between the array substrate and the opposite substrate.

14. The display panel of claim 13, wherein a plurality of test pad parts is formed in the second area.

15. The display panel of claim 13, further comprising:
a gate driving part applying gate signals to the gate lines, and applying a dummy gate signal to the dummy gate line; and
a data driving part applying data signals to the data lines, and applying a dummy data signal to the dummy data line.

16. The display panel of claim 15, wherein the data driving part is formed in the second area.

17. The display panel of claim 16, wherein the gate driving part is formed in the first area, and is covered by the opposite substrate.

18. The display panel of claim 15, further comprising a gate printed circuit board on which the gate driving part is mounted, the gate printed circuit board being connected to the second area wherein the gate lines and the dummy gate line are electrically connected to the gate printed circuit board.

19. The display panel of claim 15, further comprising a data printed circuit board on which the data driving part is mounted, the data printed circuit board being connected to the second area wherein the data line and the dummy data line are electrically connected to the data printed circuit board.
